# EUROPEAN PATENT APPLICATION

(11) **EP 4 486 077 A1**
(43) Date of publication of application: **01.01.2025**
(21) Application number: 24183958.8
(22) Date of filing: 24.06.2024
(51) Int. Cl.: H05K 1/14, H05K 3/36

(54) **WIRE BONDING FOR MINIATURIZING PRINTED CIRCUIT INTERCONNECTION**

(30) Priority: 27.06.2023 US 202363523557 P; 18.06.2024 US 202418747330
(71) Applicant: Meta Platforms Technologies, LLC, Menlo Park, CA 94025 (US)
(72) Inventor: Bardagjy, Andrew Matthew, Menlo Park (US); Liao, Guangxun, Menlo Park (US)
(74) Representative: Murgitroyd & Company

(57) **Abstract**

Techniques are described for electrically connecting printed circuit modules 110, 120 using wire bonding. A first printed circuit module 110 may have one or more bonding pads 150 electrically coupled with one or more electrical components of the first printed circuit module, and a second printed circuit module 120 may have one or more bonding pads 150 electrically coupled with one or more electrical components 130 of the second printed circuit module 120. One or more wire bonds 140 may be used to electrically connect the one or more bonding pads of the first printed circuit module to the one or more bonding pads of the second printed circuit module. A protective structure may be used to cover at least a portion of the one or more wire bonds.

## Description

### FIELD OF THE INVENTION

The present disclosure generally relates to electronic devices, and specifically relates to wire bonding for miniaturizing interconnection.

### BACKGROUND

Electronic devices such as mobile phones, tablet computers, wearable devices (e.g., headsets, watches, rings, etc.), and the like will often have multiple printed circuit modules, where each printed circuit module has circuitry and/or other components of the electronic device. Splitting the electronics into different modules in this manner can help provide flexibility in reducing the size of the electronic devices, allowing for different modules to be located in different parts of the electronic device, rather than having a single (large) module. Conventionally, various printed circuit modules are electronically connected using connectors such as board-to-board (B2B) connectors (also known as BtoB or BTB), gold fingers, and anisotropic conductive film (ACF), which typically have a pitch of greater than 150 microns.

### SUMMARY

Described herein are techniques for enabling wire bonding between different printed circuit modules. More specifically, printed circuit modules, including inflexible modules (e.g., having a printed circuit board (PCB) substrate) and/or flexible modules (e.g., having a flexible printed circuit (FPC) substrate) may be electrically connected using wire bonding. To do so, embodiments may utilize certain alignment techniques, reinforcement plates, and/or protective structures for the wire bonds, as described in the embodiments provided herein. Because wire bonding can have a pitch of less than 150 µm, the techniques herein can enable electronics to be miniaturized, which may enable devices (e.g., wearable devices) to have smaller form factors.

According to an aspect, there is provided an electronic device comprising:
a first printed circuit module comprising:
   a first printed circuit substrate, and
   a first set of one or more bonding pads coupled to the first printed circuit substrate;
a second printed circuit module comprising:
   a second printed circuit substrate, and
   a second set of one or more bonding pads coupled to the second printed circuit substrate;
one or more wire bonds electrically connecting first set of one or more bonding pads to the second set of one or more bonding pads; and
a protective structure covering at least a portion of the one or more wire bonds and coupled with the first printed circuit substrate and second printed circuit substrate.

The first set of one or more bonding pads may be located on a first side of the first printed circuit substrate, and the second set of one or more bonding pads may be located on a first side of the second printed circuit substrate. A first portion of a reinforcement plate may be coupled to a second side of the first printed circuit substrate opposite the first side of the first printed circuit substrate. A second portion of the reinforcement plate may be coupled to a second side of the second printed circuit substrate opposite the first side of the second printed circuit substrate.

The first printed circuit module may be coupled to the second printed circuit module.

The first set of one or more bonding pads may be located on a first side of the first printed circuit substrate. The first printed circuit module may comprise a cut-out extending from the first side of the first printed circuit substrate to a second side of the first printed circuit substrate opposite the first side of the first printed circuit substrate. The one or more wire bonds may extend through the cut-out from the first set of one or more bonding pads to the second set of one or more bonding pads.

The protective structure may comprise a shielding can covering at least a portion of the one or more wire bonds. The protective structure may comprise a molding compound encapsulating the at least a portion of the one or more wire bonds.

The first printed circuit substrate, the second printed circuit substrate, or both, may comprise a printed circuit board (PCB) substrate. The first printed circuit substrate, the second printed circuit substrate, or both, may comprise a flexible printed circuit (FPC) substrate.

The first set of one or more bonding pads, the second set of one or more bonding pads, or both, may have a pitch of less than 100 microns.

According to another aspect, there is provided a method of interconnecting printed circuits with wire bonding, the method comprising:
forming one or more wire bonds electrically connecting one or more bonding pads of a first printed circuit module to one or more bonding pads of a second printed circuit module, wherein each of the first printed circuit module and the second printed circuit module comprise a respective printed circuit substrate; and
forming a protective structure covering at least a portion of the one or more wire bonds, the protective structure coupled with the respective printed circuit substrate of each of the first printed circuit module and the second printed circuit module.

The one or more bonding pads of the first printed circuit module may be located on a first side of the respective printed circuit substrate of the first printed circuit module, and the one or more bonding pads of the second printed circuit module may be located on a first side of the respective printed circuit substrate of the second printed circuit module. The method may further comprise, prior to forming one or more wire bonds:
adhering a first portion of a reinforcement plate to a second side of the respective printed circuit substrate of the first printed circuit module opposite the first side of the respective printed circuit substrate of the first printed circuit module; and
adhering a second portion of the reinforcement plate to a second side of the respective printed circuit substrate of the second printed circuit module opposite the first side of the respective printed circuit substrate of the second printed circuit module.

Adhering the first portion of the reinforcement plate to the second side of the respective printed circuit substrate of the first printed circuit module may occur prior to a singulation of the first printed circuit module from a printed circuit panel comprising the first printed circuit module and one or more additional printed circuit modules.

Adhering the second portion of the reinforcement plate to the second side of the respective printed circuit substrate of the second printed circuit module may occur subsequent to the singulation of the first printed circuit module from the printed circuit panel.

The method may include, prior to forming one or more wire bonds, adhering the first printed circuit module to the second printed circuit module.

The one or more bonding pads of the first printed circuit module may be located on a first side of the respective printed circuit substrate of the first printed circuit module.

The first printed circuit module may comprise a cut-out extending from the first side of the respective printed circuit substrate of the first printed circuit module to a second side of the respective printed circuit substrate of the first printed circuit module opposite the first side of the respective printed circuit substrate of the first printed circuit module.

Forming the one or more wire bonds may comprise forming the one or more wire bonds to extend through the cut-out from the one or more bonding pads of the first printed circuit module to the one or more bonding pads of the second printed circuit module.

Forming the protective structure may comprise:
securing a shielding can covering at least a portion of the one or more wire bonds, and/or
encapsulating the one or more wire bonds with a molding compound.

The respective printed circuit substrate of the first printed circuit module, the respective printed circuit substrate of the second printed circuit module, or both, may comprise:
a printed circuit board (PCB) substrate, or
a flexible printed circuit (FPC) substrate.

The one or more bonding pads of the first printed circuit module, the one or more bonding pads of the second printed circuit module, or both, may have a pitch of less than 100 microns.

According to a further aspect, there is provided a set of electrically connected printed circuit modules comprising:
a first printed circuit module having one or more bonding pads electrically coupled with one or more electrical components of the first printed circuit module;
a second printed circuit module having one or more bonding pads electrically coupled with one or more electrical components of the second printed circuit module;
one or more wire bonds electrically connecting the one or more bonding pads of the first printed circuit module to the one or more bonding pads of the second printed circuit module; and
a protective structure covering at least a portion of the one or more wire bonds.

This summary is neither intended to identify key or essential features of the claimed subject matter, nor is it intended to be used in isolation to determine the scope of the claimed subject matter. The subject matter should be understood by reference to appropriate portions of the entire specification of this disclosure, any or all drawings, and each claim. The foregoing, together with other features and examples, will be described in more detail below in the following specification, claims, and accompanying drawings.

### BRIEF DESCRIPTION OF THE DRAWINGS

FIG. 1 is an illustration of an example device electronics having printed circuit modules, according to an embodiment.
FIGS. 2A and 2B provide examples of two of types of connections using wire bonding, according to some embodiments.
FIGS. 3A-3D illustrate variations of a type of connection that may be used with wire bonding in which a first printed circuit substrate is fixed to a second printed circuit substrate, according to some embodiments.
FIGS. 4A-4E are illustrations of example interfaces for which wire bonding may be used, according to some embodiments.
FIGS. 5A-5G illustrate a series of operations in an example manufacturing process that can be used to form the wire bonding connections described in the embodiments herein.
FIG. 6 is a flow diagram of a method of interconnecting printed circuits with wire bonding, according to an embodiment.
FIG. 7 is a diagram of an example head mounted device (HMD) that may use the wire bonding connections described in the embodiments herein.

The figures depict embodiments of the present disclosure for purposes of illustration only. One skilled in the art will readily recognize from the following description that alternative embodiments of the structures and methods illustrated may be employed without departing from the principles described herein.

### DETAILED DESCRIPTION

Electric devices such as mobile phones, wearable devices (e.g., headsets, earbuds, watches, etc.), tablets, and the like often will have multiple printed circuit modules embedded at different locations within the body of the device. The substrates for these printed circuit modules may vary, depending on manufacturing limitations, desired functionality, and the like. Traditional printed circuit board (PCB) may have an inflexible substrate, which may comprise glass fiber, epoxy, and/or other inflexible materials. Flexible printed circuit (FPC) substrates, on the other hand, comprise flexible materials like polyester or polyimide film, allowing an FPC-based printed circuit module to bend. This ability to separate electronics into separate printed circuit modules, along with other traits such as the flexibility of FPC, have allowed manufacturers to continue to miniaturize electronics, allowing for increasingly smaller electronic devices.

As used herein, the terms "printed circuit" and "printed circuit modules" refer to PCB, FPC, and similar structures to which various components are electrically connected (e.g., using surface mount, through-hole, or other soldering techniques) and which provide electrical interconnection between such components. In this way, printed circuits are distinct from integrated circuits (ICs) in that various components of ICs (transistors, resistors, etc.) are built directly into the substrate (e.g., semiconductor) of the IC. Put differently, components of an IC are formed from the substrate of the IC itself, whereas components of a printed circuit are fully formed components for which the printed circuit provides an electrical connection to other circuitry/components.

However, as electronic devices become smaller, the connections between different printed circuit modules have become a bottleneck to continued miniaturization. For example, board-to-board (B2B) connectors (also known as BtoB or BTB) and gold fingers (or edge connectors) use connector jackets that can be bulky (e.g., relative to the printed circuit module). Anisotropic conductive film (ACF) uses a high-temperature process that can damage components that are incorporated into a printed circuit module. Further, the pitch (distance from the center of one pin to the center of a neighboring pen) of connectors using these traditional techniques is typically larger than 150 µm, which can also stand in the way of miniaturization.

Described herein are techniques for enabling wire bonding between different printed circuit modules. More specifically, printed circuit modules, including inflexible modules (e.g., PCB) and/or flexible modules (e.g., FPC) may be electrically connected using wire bonding. To do so, embodiments may utilize certain alignment techniques, reinforcement plates, and/or protective structures for the wire bonds, as described in the embodiments provided herein. Because wire bonding can have a pitch of less than 150 µm, the techniques herein can enable electronics to be miniaturized, which may enable devices (e.g., wearable devices) to have smaller form factors.

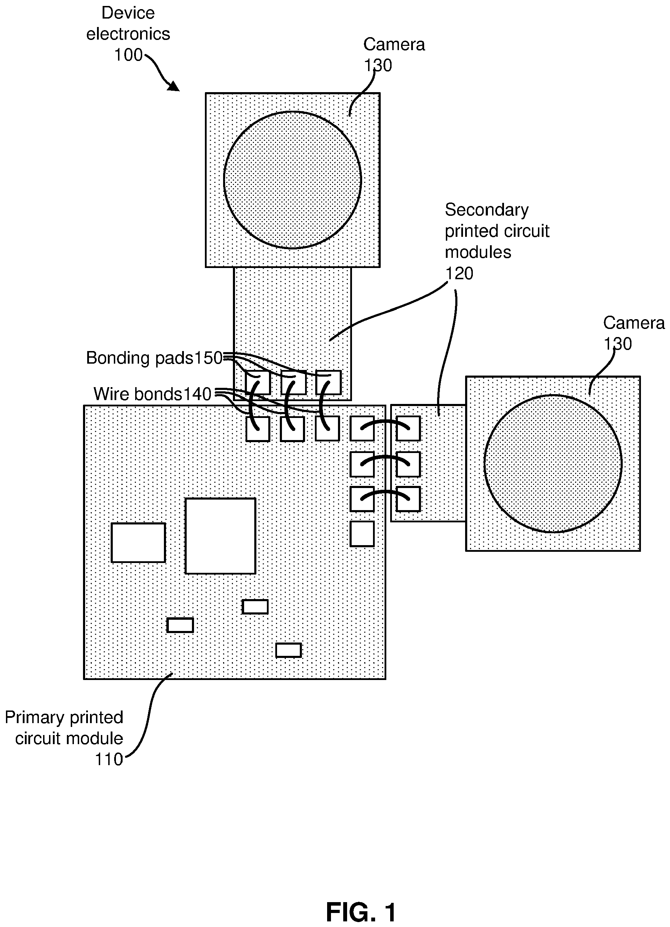

**FIG. 1** is an illustration of example device electronics 100, according to an embodiment. Here, the device electronics 100 comprise a primary printed circuit module 110 and two secondary printed circuit modules 120. In this example, each secondary printed circuit module 120 further includes a camera 130. The device electronics 100 may be incorporated into a headset, for example, having multiple cameras (e.g., cameras 130) to capture images of the headset wearer's environment. The primary printed circuit module 110 and secondary printed circuit modules 120 each may comprise an inflexible module (e.g., PCB) or flexible module (e.g., FPC), depending on manufacturing limitations, desired functionality, cost, and/or other such factors. As with other figures herein, FIG. 1 is provided as a nonlimiting example, and alternative embodiments may have different features. For example, depending on the type of electronic device, printed circuit modules may comprise additional or alternative electronic components, including components providing audio, display, processing, and/or other capabilities.

As noted above, traditional techniques for connecting the primary printed circuit module 110 with secondary printed circuit modules 120 may not work in this case. For example, the headset may include a form factor that looks like traditional glasses, in which case the device electronics 110 may need to be incorporated into the frame of the glasses. The connector jackets associated with BtoB and gold finger may be too bulky to be incorporated into the frame of the glasses. Further, the high temperature required for ACF may damage the cameras 130. Further, as noted above, the pitch of the connectors using any of these traditional technologies may limit the degree to which the device electronics 100 may be miniaturized.

According to embodiments herein, printed circuit modules (e.g., primary printed circuit module 110 and secondary printed circuit modules 120) may be connected using wire bonds 140, which electrically connect the secondary printed circuit modules 120 to the primary printed circuit module 110 via bonding pads 150. (To avoid clutter, only a portion of wire bonds 140 and bonding pads 150 of FIG. 1 have been labeled.) In particular, the wire bonds 140 may electrically connect the cameras 130 to the circuitry of the primary printed circuit module 110. (In this case, the circuitry of the primary printed circuit module 110 may include a microprocessor and/or other circuitry to process images captured by the cameras 130.) Wire bonding can have a smaller pitch than traditional connecting techniques (e.g., current wire bonding can provide for pitches as low as 88 µm, and future wire bonding may include even smaller pitches), and other structural components associated with wire bonding (described below) may be less bulky than structural components associated with traditional techniques for connecting printed circuit modules. Furthermore, according to some embodiments, printed circuit modules may be capable of sharing common bonding pads rather than having the separate connectors required by traditional connecting techniques. Moreover, as described in more detail below, wire bonding can accommodate irregular interfaces between printed circuit modules. Given these advantages of wire bonding, embodiments can provide for the miniaturization of electrical devices in a manner not possible using traditional techniques.

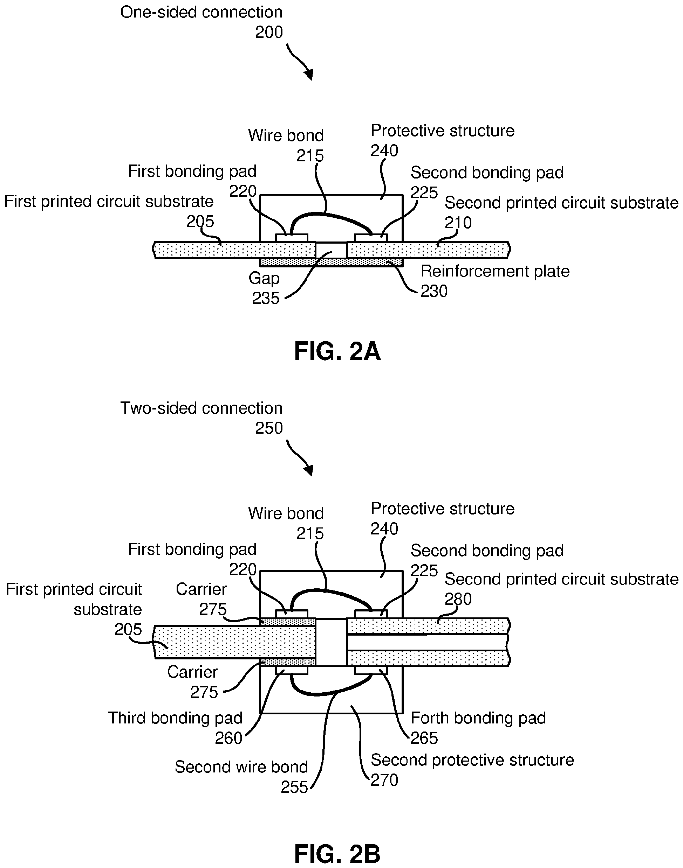

As described in the additional embodiments below, wire bonding may be applied to various types of connections between printed circuit modules. FIGS. 2A and 2B provide examples of two of these types of connections.

**FIG. 2A** is a cross-section view of an example one-sided connection 200, according to an embodiment. In this example, the one-sided connection 200 connects a first printed circuit module with a first printed circuit substrate 205 with a second printed circuit module having a second printed circuit substrate 210. As previously noted, these printed circuit substrates 205 and 210 may comprise the same materials or may comprise different materials. (Other figures herein may illustrate portions of printed circuit modules, which may include their respective printed circuit substrates, labeled as such.) For example, one may be PCB, while the other may be FPC. Alternatively, both may be PCB or FPC. Also, similar to the example of FIG. 1, the wire bond 215 in this one-sided connection 200 connects a first bonding pad 220 with a second bonding pad 225. (It can be noted that, although the first bonding pad 220 and second bonding pad 225 are illustrated as extending above the first printed circuit substrate 205 and second printed circuit substrate 210, respectively, this may or may not be the case, depending on the type of processes used to form the first bonding pad 220 and second bonding pad 225.)

According to some embodiments, to provide some additional structural integrity to the one-sided connection 200, a reinforcement plate 230 may be used. That is, the reinforcement plate 230 may be fixed to both the first printed circuit substrate 205 and the second printed substrate 210 to help minimize movement between the two printed circuit substrates 205, 210 that could potentially break the wire bond 215, detach the wire bond 215 from one of the bonding pads 220 or 225, or otherwise compromise the electrical connection made by wire bond 215. To provide this structural reinforcement, the reinforcement plate 230 may comprise a relatively strong material, such as stainless steel (e.g., sheet metal), fiberglass, FR4, a strong plastic (e.g., polyamide), or a combination thereof. According to some embodiments, the reinforcement plate 230 may be fixed to the first printed circuit substrate 205 and the second printed circuit substrate 210 with an adhesive, such as a temperature-activated adhesive, pressure-sensitive adhesive, or the like. (In some embodiments, different adhesives may be used if the first printed circuit substrate 205 and second printed circuit substrate 210 comprise different materials.) It can be noted that although a gap 235 is illustrated in the one-sided connection 200 of FIG. 2A, alternative embodiments may exist in which the first printed circuit substrate 205 abuts against the second printed circuit substrate 210 such that there is little or no space between them. In any case, the use of a reinforcement plate 230 can help preserve the structural integrity of the one-sided connection 200.

Additionally, as illustrated in FIG. 2A, a protective structure 240 may be used to protect the wire bond 215. In some embodiments, the protective structure 240 may also be coupled with and may help reduce movement between the first printed circuit substrate 205 and the second printed circuit substrate 210. As with other features of the one-sided connection 200, the material(s) with which the protective structure 240 is made may vary, depending on one or more factors, such as cost, manufacturing concerns, desired functionality, or the like. According to some embodiments, the protective structure 240 may comprise a shielding can be formed to cover at least a portion of the wire bond 215 using sheet metal, for example, protecting the wire bond 215 from impact by an object. According to some embodiments, the protective structure 240 may comprise a molding compound (e.g., epoxy) or other encapsulant surrounding the wire bond 215. In such embodiments, the encapsulated may be simply deposited over the wire bond 215. Alternatively, a low-pressure plastic molding may be used to help ensure the wire bond 215 is not damaged. For example, a thermoplastic polyurethane (TPU) overmold may be used. Further, depending on desired functionality, the protective structure 240 may be shaped to help ensure compliance with space-constrained applications. For embodiments in which an encapsulant is used for the protective structure 240, such shaping may be performed using a mold or dam around the joint between the printed circuit modules, and/or by removing deposited material. It can be noted that, although a single wire bond 215 as illustrated in the cross-sectional diagram of FIG. 2A, a one-sided connection 200 may comprise many adjacent wire bonds (e.g., as illustrated in FIG. 1). In such embodiments, a single protective structure 240 may be used to protect a group of adjacent wire bonds 215. That said, a plurality of protective structures 240 may be used to protect a plurality of wire bonds 215, depending on the desired functionality.

**FIG. 2B** illustrates an example two-sided connection 250, according to an embodiment. Here, the two-sided connection 250 includes many of the same features as illustrated in the one-sided connection 200 of FIG. 2A, as indicated in FIG. 2B with features having the same labels/label numbers. Additionally, many of the same features on the second side (the side of the two-sided connection 250 facing the bottom of FIG. 2B) may be similar to those previously described, including a second wire bond 255 connecting a third bonding pad 260 to a fourth bonding pad 265, and a second protective structure 270. These features may be formed in the same manner as described above with respect to FIG. 2A. Depending on the manufacturing processes used, features on a first side of the two-sided connection 250 may need to be formed before forming the features on the second side.

As illustrated, the two-sided connection 250 of FIG. 2B may include some differences from the single-sided connection 200 of FIG. 2A. For example, a carrier 275 may be used on one or both sides of the first printed substrate 205 to provide support to the first bonding pad 220 and the third bonding pad 260 of the first printed circuit substrate 205. Thus, according to some embodiments, the carrier 275 may comprise part of the printed circuit design and may be formed on the first printed circuit substrate 205 as part of the printed circuit. The carrier 275 may be used, for example, to provide rigidity/reinforcement to the first printed circuit substrate 205 in cases where the first printed substrate 205 may needed (e.g., if the first printed substrate 205 comprises FPC). As further illustrated, the second printed circuit substrate 280 may comprise a two-sided printed circuit substrate, in which case the second printed circuit substrate 280 illustrated in FIG. 2B may represent a stack of materials common to two-sided printed circuit substrates. According to some embodiments, two printed circuit substrates may be adhered together or to a common structure (e.g., a reinforcement plate) to form the double-sided second printed circuit substrate 280.

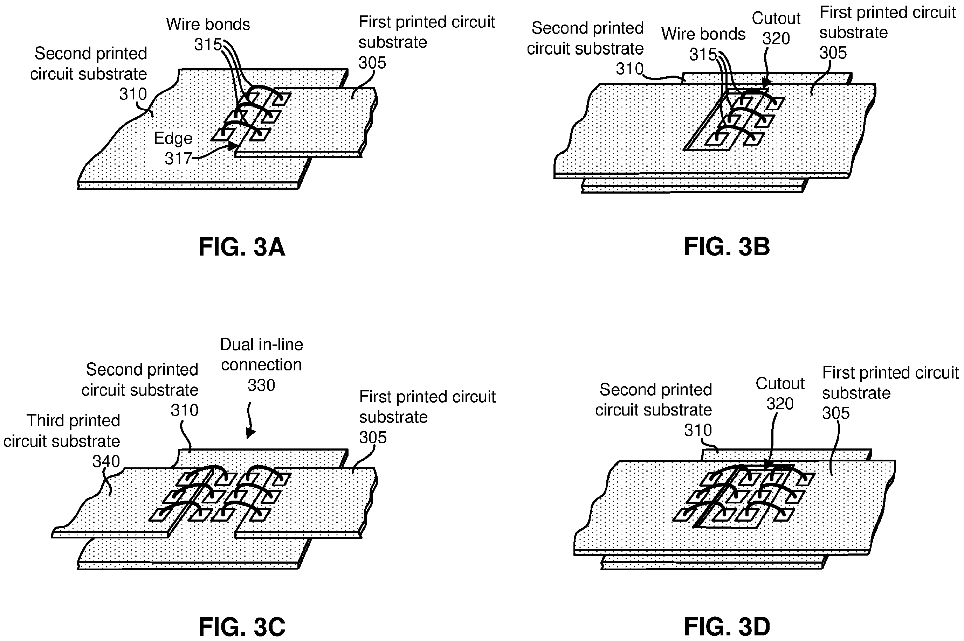

**FIGS. 3A-3D** illustrate variations of a type of connection that may be used with wire bonding in which a first printed circuit substrate 305 is fixed (e.g., using adhesive) to a second printed circuit substrate 310, according to some embodiments. In these embodiments the second printed circuit substrate 310 may provide structural reinforcement for the connection. Moreover, in some embodiments, if additional reinforcement is desired, a reinforcement plate (not shown) may be adhered to the underside of the second printed circuit substrate 310 (opposite the side to which the first printed circuit substrate 305 is fixed). It can be noted that, although not illustrated, a protective structure may be formed to cover at least a portion of the wire bonds 315, as described above with respect to FIGS. 2A and 2B. Further, the number of bonding pads and wire bonds 315 illustrated in FIGS. 3A-3D is provided as an example. In practice, the number of bonding pads and wire bonds 315 may vary.

The different variations of FIGS. 3A-3D are as follows. FIG. 3A illustrates a variation in which the first printed circuit substrate 305 is fixed to the second printed circuit substrate 310. Wire bonds 315 extend from the second printed circuit substrate 310 over an edge 317 of the first printed circuit substrate 305. FIG. 3B shows a variation that illustrates how wire bonds 315 do not necessarily need to be located near an edge of the first printed circuit substrate 305. Instead, wire bonds 315 extend from the second printed circuit substrate 310 through a cutout 320 of the first printed substrate 305 to connect to bonding pads of the first printed substrate 305. FIG. 3C illustrates how a dual in-line connection 330 can be used to allow the second printed circuit substrate 310 to connect with both the first printed circuit substrate 305 and a third printed circuit substrate 340. Finally, FIG. 3D shows a variation that combines features of the variations of FIG. 3B and FIG. 3C, showing how a dual in-line connection 330 can be used with a cutout 320 when wire bonding connections between the first printed circuit substrate 305 and the second printed circuit substrate 310.

Embodiments may utilize different alignment techniques to enable wire bonding between printed circuit modules as described herein. That is, substrates, reinforcement plates, system components, and/or other components may need to be properly aligned before wire bonding can take place. According to some embodiments, optical alignment and mechanical alignment are two such alignment techniques that may be used.

Optical alignment involves the use of a vision system to align two components (e.g., two printed circuit modules) with each other using optical tools, such as cameras. For example, a first component may be placed on a working surface, and a second component may be placed (e.g., using a pick-and-place tool) based on visual features identified by the vision system. These features may include bonding pads and/or other such fiducials. Using a cutout in a first printed circuit substrate (e.g., as illustrated in FIGS. 3B and 3D), for example, can enable the vision system to see bonding pads (or other fiducials) on a second printed circuit substrate underneath the first printed circuit substrate, and perform proper alignment between the first and second printed circuit substrates prior to wire bonding.

Mechanical alignment involves using mechanical means to align two components. For example, holes may be punched in one or both components (e.g., printed circuit modules), and the components may be placed on a jig having protrusions configured to extend through the holes and align the components mechanically. According to some embodiments, mechanical alignment may use a vision system to help ensure the components are placed on the jig properly and/or verify proper placement.

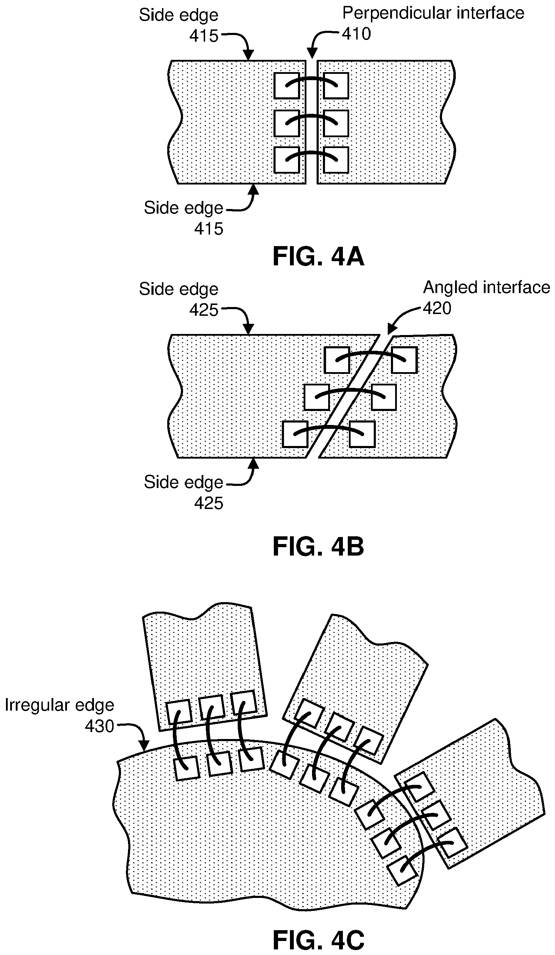

Embodiments herein can provide for wire bonding printed circuit modules in many different ways having many different interfaces. **FIGS. 4A-4E** help illustrate this point. In particular, FIG. 4A illustrates a perpendicular interface 410 between printed circuit modules in which the interface is approximately perpendicular to side edges 415 of the printed circuit modules. FIG. 4B illustrates an angled interface 420 in which the interface is angled (not perpendicular) with respect to side edges 425 of the printed circuit modules. FIG. 4C illustrates an example in which wire bonding is formed (e.g., between multiple printed circuit modules) along an irregular (non-straight) edge 430.

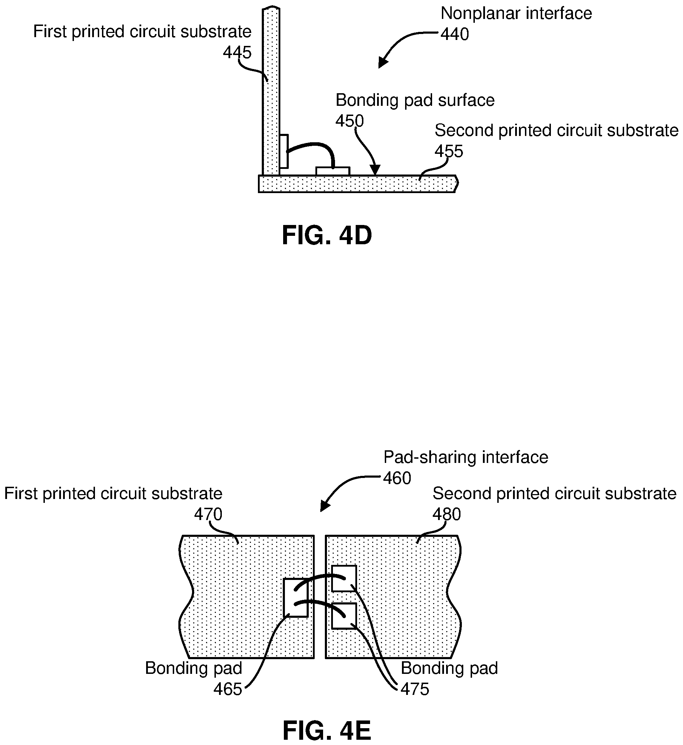

FIG. 4D illustrates a nonplanar interface 440, according to an embodiment, showing how printed circuit modules connected via wire bonding may not necessarily be coplanar. As with other interfaces shown in FIGS. 4A-4E, a nonplanar interface 440 may be used as needed to accommodate form factor limitations and/or other concerns. Further, a nonplanar interface 440 may be used in conjunction with other types of interfaces, such as those shown in FIGS. 4A-4C and 4E. In the example shown in FIG. 4D, a first printed circuit substrate 445 is secured to a bonding pad surface 450 of a second printed circuit substrate 455. However, alternative embodiments may include fastening one or both printed circuit substrates to a separate substrate or bonding item. Moreover, alternative embodiments may include nonplanar interfaces in which the first printed circuit substrate 445 and second printed circuit substrate 455 are angled in a nonplanar fashion with respect to each other (rather than being substantially perpendicular, as shown in FIG. 4D). Such nonplanar configurations (substantially perpendicular, angled, etc.) may be implemented, taking into account the capabilities and/or limitations of the wire bonding equipment for creating wire bonds to connect nonplanar printed circuit substrates.

FIG. 4E illustrates a "pad-sharing" interface 460, which illustrates an example interface in which wire bonding of bonding pads between printed circuit substrates may not reflect a unique (one-to-one) correspondence of the bonding pads. The "sharing" of bonding pads in this manner may be useful in various circumstances, such as when a bonding pad is electrically connected with a power pin, ground pin, a low-speed signal, or the like. In this specific example, a single bonding pad 465 of a first printed circuit substrate 470 is wire bonded to multiple bonding pads 475 of a second printed circuit substrate 480. As with other figures herein, embodiments are not limited to the example shown in the figure. Alternative embodiments may include any combination of correspondence between bonding pads, as desired, including one-to-one, many-to-one, many-to-few, many-to-many, etc. Further, a pad-sharing interface 460 may be used with other interfaces, such as those shown in FIGS. 4A-4D. Again, different configurations of pad-sharing interfaces may consider the capabilities and/or limitations of the wire bonding equipment for creating multiple wire bonds on a single bonding pad.

The illustrations in FIGS. 4A-4E are meant to be non-limiting examples of different types of interfaces. Alternative embodiments may utilize yet other types of interfaces, depending on desired functionality. The stability for embodiments herein to enable wire bonding using different types of interfaces can help provide flexibility in connecting printed circuit modules that can prove useful in many different applications.

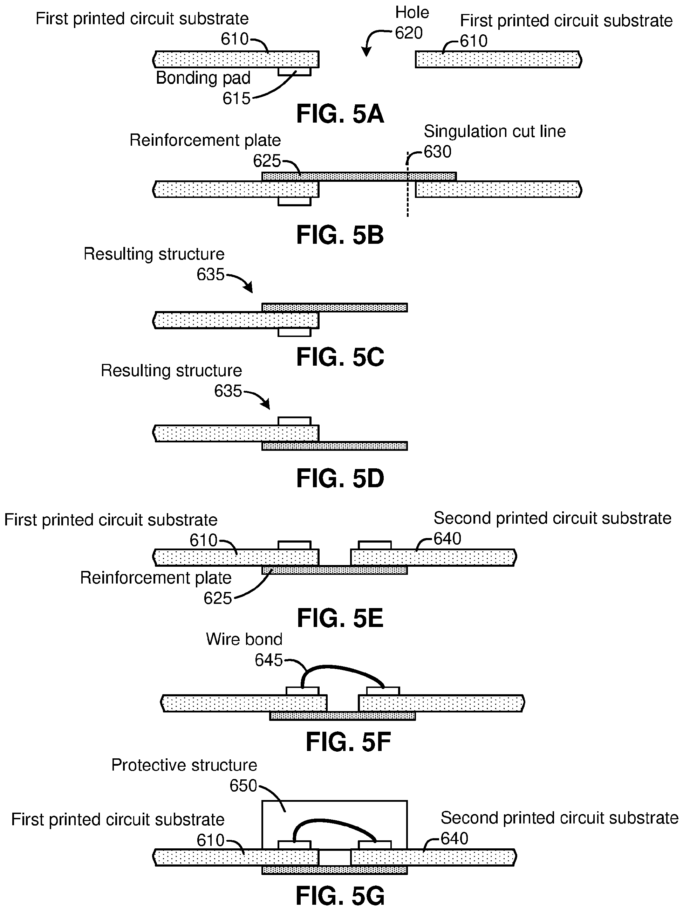

According to embodiments herein, a manufacturing process for manufacturing and connecting printed circuit modules can be adapted to accommodate the wire bonding provided herein. FIGS. 5A-5G, described below, illustrate a series of operations in a manufacturing process that can be used to form the wire bonding connections described in the embodiments herein. The process illustrated in FIGS. 5A-5G is for a one-sided connection (e.g., similar to the one-sided connection 200 of FIG. 2A). Other connection types may be adapted to accommodate and/or form different physical features of the connection.

**FIG. 5A** is an illustration of a cross-section of a portion of a first printed circuit substrate 510 during a manufacturing process. In this example, a bonding pad 515 is located next to a hole 520 in the first printed circuit substrate 510. (For multiple connections, there may be additional bonding pads next to the illustrated bonding pad 515 that are similarly adjacent to the hole 520.) As illustrated below, hole 520 may be located next to the bonding pad 515 to provide for the placement of a reinforcement plate for the subsequently formed wire bonding connection. In this example, the first printed circuit substrate 510 may be part of a large printed circuit panel comprising many (e.g., dozens or hundreds) printed circuit modules prior to singulation. Thus, holes may be situated at locations corresponding to the location of hole 520 in the printed circuit panel for all printed circuit modules. Holes may be formed, for example, using traditional techniques for patterning printed circuit substrates, and the techniques may be appended on which type of substrate is used (e.g., PCB or FPC substrate).

**FIG. 5B** illustrates a subsequent step in which a reinforcement plate 525 is placed on the first printed circuit substrate 510 over the hole 520. (To avoid clutter, FIG. 5B does not include labels for these latter components, which were labeled in FIG. 5A.) As previously noted, a reinforcement plate 525 can act as a stiffener for the connection and may comprise a relatively strong, inflexible material (e.g., stainless steel). According to some embodiments, the reinforcement plate 525 may be placed using a pick-and-place tool. As previously indicated, the reinforcement plate 525 may be aligned with the first printed circuit substrate (e.g., using visual and/or mechanical aligning, as previously discussed) and adhered to the first printed circuit substrate 510 (e.g., using a temperature-sensitive adhesive (TSA)). During simulation, the reinforcement plate 525 may then be cut at the singulation cut line 530 using, for example, traditional simulation means (e.g., laser, saw, shear, etc.). The resulting structure 535 after singulation is illustrated in **FIG. 5C**. (It can be noted that, in some embodiments, the cut illustrated in FIG. 5B may not result in singulation, but may be an intermediary cut in the manufacturing process, which may depend on manufacturing and/or other concerns.)

**FIG. 5D** illustrates a subsequent operation in the manufacturing process during which the resulting structure 535 is then turned upside down in preparation for attachment with a second printed circuit substrate. Here, the resulting structure 535 may be placed on a work surface, or carrier (not shown).

**FIG. 5E** illustrates a subsequent operation in the manufacturing process in which a structure comprising a second printed circuit substrate 540 is placed on the reinforcement plate 525. This may be done, for example, using an alignment process (e.g., visual and/or mechanical) as previously described, and the second printed circuit substrate 540 may be attached to the reinforcement plate 525 using an adhesive such as TSA, which may be placed on the reinforcement plate 525 prior to the placement of the second printed circuit substrate 540. In this example, the second printed circuit substrate 540 may be part of the completed printed circuit module that is ready for wire bonding. (If singulated at this point, the first printed circuit substrate 510 may also be part of a completed printed circuit module.)

**FIGS. 5F and 5G** illustrate the structure after subsequent operations during which a wire bond 545 and protective structure 550 are formed, respectively. According to some embodiments, the wire bond 545 may be formed in accordance with JEDEC standards, which are commonly used in microelectronic manufacturing. According to some embodiments, the wire bond 545 may be formed while the structure is on the same carrier used in the previous operation of FIG. 5E. As previously noted, the protective structure 550 may comprise, for example, a shielding can or encapsulant formed covering at least a portion of the wire bond 545 (and any other wire bonds (not shown) of the connection between the first printed circuit substrate 510 and the second printed circuit substrate 540).

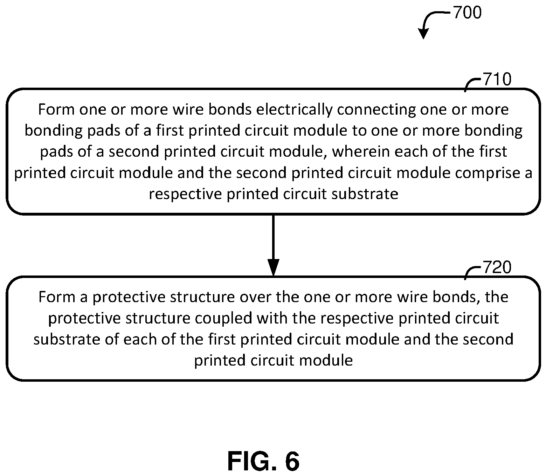

**FIG. 6** is a flow diagram of a method 600 of interconnecting printed circuits with wire bonding, according to an embodiment. The method may be used, for example, to electrically connect a set of two or more printed circuit modules, as described in the embodiments above. Means for performing the method 600 may comprise pick-and-place tools, wire bonding tools, and/or other tools used in manufacturing printed circuit modules, for example. Aspects of the method 600 may reflect the manufacturing process illustrated in FIGS. 5A-5G and/or discussed with respect to other embodiments described herein.

The method 600 may begin with the operation at block 610, which comprises forming one or more wire bonds electrically connecting one or more bonding pads of a first printed circuit module to one or more bonding pads of a second printed circuit module, wherein each of the first printed circuit module and the second printed circuit module comprise a respective printed circuit substrate. The wire bonds may be formed over a perpendicular, angle, irregular, nonplanar, or pad-sharing interface, as illustrated in FIGS. 4A-4E, for example, or a combination thereof. As noted, the printed circuit modules may be the same type or may be of different types of printed circuit. For example, according to some embodiments, the respective printed circuit substrate of the first printed circuit module, the respective printed circuit substrate of the second printed circuit module, or both, may comprise a PCB substrate. Alternatively, the respective printed circuit substrate of the first printed circuit module, the respective printed circuit substrate of the second printed circuit module, or both, may comprise an FPC substrate. The one or more bonding pads of the first printed circuit module, the one or more bonding pads of the second printed circuit module, or both, may have a pitch of less than 100 microns.

Additionally, or alternatively, the wire bonds may be formed at a point in a manufacturing process after a reinforcement plate has been adhered to the first and/or second printed circuit modules, as illustrated in FIG. 5F, for example. As such, according to some embodiments of the method 600, the bonding pads of the first printed circuit module are located on a first side of the respective printed circuit substrate of the first printed circuit module, and the bonding pads of the second printed circuit module are located on a first side of the respective printed circuit substrate of the second printed circuit module, and wherein the method further comprises, prior to forming one or more wire bonds (i) adhering a first portion of a reinforcement plate to a second side of the respective printed circuit substrate of the first printed circuit module opposite the first side of the respective printed circuit substrate of the first printed circuit module, and (ii) adhering a second portion of the reinforcement plate to a second side of the respective printed circuit substrate of the second printed circuit module opposite the first side of the respective printed circuit substrate of the second printed circuit module. The location in these operations may be performed using temperature-sensitive adhesion and/or pressure-sensitive adhesion, for example. In such embodiments, adhering the first portion of the reinforcement plate to the second side of the respective printed circuit substrate of the first printed circuit module may occur prior to a singulation of the first printed circuit module from a printed circuit panel comprising the first printed circuit module and one or more additional printed circuit modules. Further, adhering the second portion of the reinforcement plate to the second side of the respective printed circuit substrate of the second printed circuit module may occur subsequent to the singulation of the first printed circuit module from the printed circuit panel.

At block 620, the functionality comprises forming a protective structure covering at least a portion of the one or more wire bonds, the protective structure coupled with the respective printed circuit substrate of each of the first printed circuit module and the second printed circuit module. As noted herein, different types of protective structures may be used. As such, according to some embodiments, forming the protective structure may comprise securing a shielding can covering at least a portion of the one or more wire bonds or encapsulating the one or more wire bonds with a molding compound. As previously noted, a molding compound may comprise an epoxy or low-pressure plastic molding, for example. As also previously noted, according to some embodiments, the molding compound may be shaped by using a dam or mold shape the molding compound and/or by removing portions of the molding compound.

As previously discussed with respect to FIGS. 3A-3D, some connections may involve coupling a first printed substrate to a second printed circuit substrate. As such, some embodiments of the method 600 may comprise, prior to forming one or more wire bonds, adhering the first printed circuit module to the second printed circuit module. In such embodiments, the bonding pads of the first printed circuit module may be located on a first side of the respective printed circuit substrate of the first printed circuit module, and the first printed circuit module may comprise a cut-out extending from the first side of the respective printed circuit substrate of the first printed circuit module to a second side of the respective printed circuit substrate of the first printed circuit module opposite the first side of the respective printed circuit substrate of the first printed circuit module. In such embodiments, forming the one or more wire bonds may comprise forming the one or more wire bonds to extend through the cut-out from the one or more bonding pads of the first printed circuit module to the one or more bonding pads of the second printed circuit module. Examples of such embodiments are illustrated in FIG. 3B and 3D, which are discussed above.

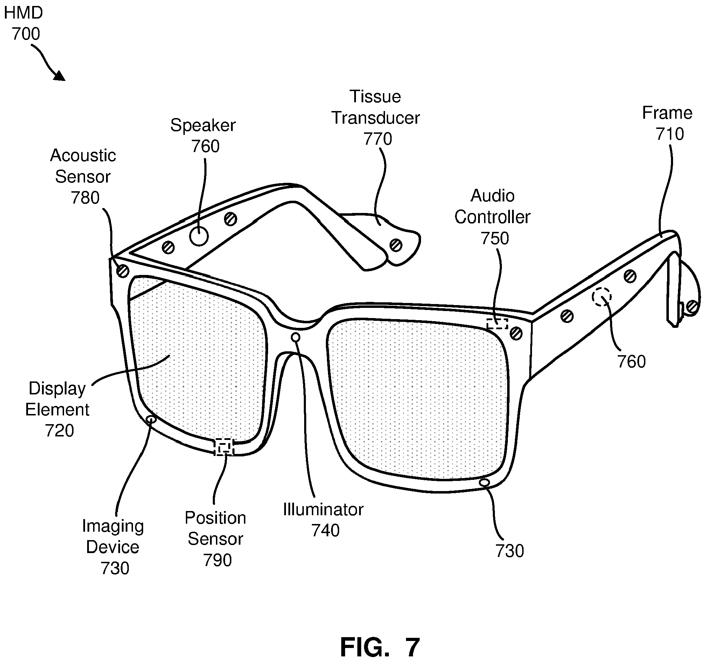

As noted, the embodiments for wire bonding described herein can allow for miniaturization of device electronics (e.g., as shown in FIG. 1), which can enable increasingly sophisticated electronics to be incorporated into increasingly smaller form factors. This can include wearable devices such as rings, watches, and headsets. FIG. 7, described below, provides an example.

**FIG. 7** is a perspective view of a head-mounted device (HMD) 700, implemented as an eyewear device, that may use the wire bonding connections described in the embodiments herein. HMDs may comprise different types of electronic devices, such as an artificial intelligence (AI) assistant, a virtual reality (VR) device, or augmented reality (AR) device - all of which may utilize the wire bonding techniques described herein. The particular example HMD 700 of FIG. 7 illustrates a headset with a form factor similar to traditional eyeglasses. Various device electronics may be housed within the frame 710, which may accommodate only small and irregularly shaped spaces for printed circuits in other components. Thus, the techniques herein for wire bonding for miniaturizing printed circuit interconnection are particularly well-suited for the HMD 700.

In general, the HMD 700 may be worn on the face of a user such that content (e.g., media content) is presented using a display assembly and/or an audio system, both of which are integrated into the HMD 700. However, the HMD 700 may also be used such that media content is presented to a user in a different manner. Examples of media content presented by the HMD 700 include images, video, audio, or some combination thereof. The HMD 700 may include a frame 710, a display assembly including one or more display elements 720, a depth camera assembly (DCA), an audio system, and a position sensor 790. While FIG. 7 illustrates the components of the HMD 700 in example locations on the HMD 700, the components may be located elsewhere on the HMD 700 and/or on an external device paired with the HMD 700. Similarly, the HMD 700 may include fewer or more components than what is shown in FIG. 7.

The frame 710 holds the other components of the HMD 700. The frame 710 includes a front part that holds the one or more display elements 720 and end pieces (e.g., temples) to attach to a head of the user. The front part of the frame 710 bridges the top of a nose of the user. The length of the end pieces may be adjustable (e.g., adjustable temple length) to fit different users. The end pieces may also include a portion that curls behind the ear of the user (e.g., a temple tip or earpiece).

The one or more display elements 720 provide light to a user wearing the HMD 700. As illustrated, the HMD may include a separate display element 720 for each eye of the user. In some embodiments, a display element 720 generates image light that is directed to an eyebox of the HMD 700. The eyebox is a location in space that an eye of user occupies while wearing the HMD 700. For example, a display element 720 may be a waveguide display. A waveguide display includes a light source (e.g., a two-dimensional source, one or more line sources, one or more point sources, etc.) and one or more optical waveguides. Light from the light source is in-coupled into the one or more optical waveguides, which output the light in a manner such that there is pupil replication in an eyebox of the HMD 700. In-coupling and/or outcoupling of light from the one or more optical waveguides may be done using one or more diffraction gratings. In some embodiments, the waveguide display includes a scanning element (e.g., a rotating mirror or prism) that scans light from the light source as it is in-coupled into the one or more waveguides. Note that in some embodiments, one or both of the display elements 720 are opaque and do not transmit light from a local area around the HMD 700. The local area is the area surrounding the HMD 700. For example, the local area may be a room that the user wearing the HMD 700 is inside, or the user wearing the HMD 700 may be outside and the local area is an outside area. When one or more display elements 720 are opaque, the HMD 700 may generate virtual reality (VR) content. Alternatively, in some embodiments, one or both of the display elements 720 are at least partially transparent, such that light from the local area may be combined with light from the one or more display elements 720 to produce augmented reality (AR) and/or mixed reality (MR) content.

In some embodiments, a display element 720 does not generate image light, and instead is a lens that is optically transparent in order to transmit light from the local area to the eyebox. For example, one or both of the display elements 720 may be a lens without correction (non-prescription) or a prescription lens (e.g., single vision, bifocal, trifocal, or progressive) to help correct for defects in a user's eyesight. In some embodiments, the display element 720 may be polarized and/or tinted to protect the user's eyes from the sun.

In some embodiments, the display element 720 may include an additional optics block (not shown in FIG. 7). The optics block may include one or more optical elements (e.g., a spherical lens, a Fresnel lens, etc.) that direct light from the display element 720 to the eyebox. The optics block may, for example, correct for aberrations in some or all of the image content, magnify some or all of the image, or some combination thereof.

The DCA determines depth information for a portion of a local area surrounding the HMD 700. The DCA includes one or more imaging devices 730 and a DCA controller (not shown in FIG. 7) and may also include an illuminator 740. The illuminator is a light source that illuminates a portion of the local area with light. The light from the illuminator 740 may include structured light (e.g., a dot pattern or bar pattern) in a non-visible (e.g., infrared) spectrum. In some embodiments, the one or more imaging devices 730 capture images of the illuminated portion of the local area. FIG. 7 shows a single illuminator 740 and two imaging devices 730. In alternate embodiments, there at least two imaging devices but no illuminator.

The DCA controller computes depth information for the illuminated portion of the local area using the captured images and one or more depth determination techniques. The depth determination techniques may, for example, include direct time-of-flight (ToF) depth sensing, indirect ToF depth sensing, structured light sensing, passive stereo analysis, active stereo analysis (using texture added to the scene by light from the illuminator 740), some other technique to determine the depth of a scene or some combination thereof.

The audio system of HMD 700 may include a transducer array, an acoustic sensor array, and an audio controller 750. The audio system may provide audio content using the transducer array, which may include a set of speakers 760 (e.g., a separate speaker for each ear). However, in other embodiments, the audio system may include different and/or additional components. Similarly, in some cases, functionality described with reference to the components of the audio system can be distributed among the components in a different manner than is described here. For example, some or all of the functions of the audio controller in FIG. 7 (or other examples illustrated herein) may be performed by a remote server.

Audio controller 750 processes information from the sensor array that describes sounds captured by the sensor array. The audio controller 750 may include a processor and a computer-readable storage medium. The audio controller 750 may be configured to generate direction of arrival (DOA) estimates, generate acoustic transfer functions (e.g., array transfer functions (ATFs) and/or head-related transfer functions (HRTFs)), track the locations of sound sources, form beams in the direction of sound sources, classify sound sources, generate sound filters for filtering audio content to be presented through the speakers 760, or some combination thereof.

The transducer array presents sound to the user. The transducer array includes a plurality of transducers. A transducer may be a speaker 760 or a tissue transducer 770 (e.g., a bone conduction transducer or a cartilage conduction transducer). The speakers 760 may be located external to the frame 710 or enclosed within the frame 710. In some embodiments, instead of individual speakers for each ear, the HMD 700 includes a speaker array comprising multiple speakers integrated into the frame 710 to improve the directionality of presented audio content. The tissue transducer 770 couples to the head of the user and directly vibrates tissue (e.g., bone or cartilage) of the user to generate sound. The number and/or locations of transducers may be different from what is shown in FIG. 7.

The sensor array captures sound within the local area (e.g., a room) of the HMD 700. The sensor array includes a plurality of acoustic sensors 780. An acoustic sensor 780 captures sounds emitted from one or more sound sources in the local area. The one or more sound sources may be in the far field (e.g., a noise source, a person speaking, etc.), the near field (e.g., a voice of the user), or some combination thereof. Each acoustic sensor is configured to capture sound and convert the captured sound into an electronic format (analog or digital). The acoustic sensors 780 may be acoustic wave sensors, microphones, contact microphones, sound transducers, voice activity detectors (VADs), or similar sensors that are suitable for capturing sounds and/or vibrations.

In some embodiments, one or more acoustic sensors 780 may be placed in an ear canal of each ear (e.g., acting as binaural microphones). In some embodiments, the acoustic sensors 780 may be placed on an exterior surface of the HMD 700, placed on an interior surface of the HMD 700, separate from the HMD 700 (e.g., part of some other device), or some combination thereof. The number and/or locations of acoustic sensors 780 may be different from what is shown in FIG. 7. For example, the number of acoustic capture locations may be increased to increase the amount of audio information collected and the sensitivity and/or accuracy of the information. The acoustic capture locations may be oriented such that the microphone is able to capture sounds in a wide range of directions surrounding the HMD 700.

The position sensor 790 generates one or more measurement signals in response to motion of the HMD 700. The position sensor 790 may be located on a portion of the frame 710. The position sensor 790 may include an inertial measurement unit (IMU). Examples of position sensor 790 include: one or more accelerometers, one or more gyroscopes, one or more magnetometers, another type of sensor that detects motion, a sensor used for error correction of the IMU, or some combination thereof.

In some embodiments, the HMD 700 may provide for simultaneous localization and mapping (SLAM) for a position of the HMD 700 and updating of a model of the local area. For example, the HMD 700 may include a passive camera assembly (PCA) that generates color image data. The PCA may include one or more RGB (red, green, blue) cameras that capture images of some or all of the local area. In some embodiments, at least some of the imaging devices 730 of the DCA may also function as the PCA. The images captured by the PCA and the depth information determined by the DCA may be used to determine parameters of the local area, generate a model of the local area, update a model of the local area, or some combination thereof. Furthermore, the position sensor 790 tracks the position (e.g., location and pose) of the HMD 700 within the room. The images captured by the HMD 700 may be used to determine the locations of sound sources in the local area.

The wire bonding techniques described herein may be used in an HMD such as HMD 700, in various ways. According to some embodiments, an HMD may include a first printed circuit module comprising a first printed circuit substrate, and a first set of one or more bonding pads coupled to the first printed circuit substrate. The HMD further may include second printed circuit module comprising a second printed circuit substrate, and a second set of one or more bonding pads coupled to the second printed circuit substrate. One or more wire bonds may electrically connecting the first set of one or more bonding pads to the second set of one or more bonding pads, and a protective structure may cover at least a portion of the one or more wire bonds and may be coupled with the first printed circuit substrate and second printed circuit substrate.

Embodiments may include one or more of the following additional features, depending on desired functionality. The HMD may comprise an AR or a VR device. One or more of the following types of components may be electrically coupled to (e.g., soldered to) the first printed circuit module, the second printed circuit module, or both: a display element, an imaging device, a position sensor, an illuminator, an audio controller, and acoustic sensor, a speaker, a tissue transducer, a microcontroller, or a processor. The first printed circuit module, the second printed circuit module, or both, may be embedded or otherwise incorporated into the body or frame of the HMD. Embodiments of an HMD additionally or alternatively may include one or more other features described in the embodiments herein.

The methods, systems, and devices discussed above are examples. Various embodiments may omit, substitute, or add various procedures or components as appropriate. For instance, in alternative configurations, the methods described may be performed in an order different from that described, and/or various stages may be added, omitted, and/or combined. Also, features described with respect to certain embodiments may be combined in various other embodiments. Different aspects and elements of the embodiments may be combined in a similar manner. Also, technology evolves and, thus, many of the elements are examples that do not limit the scope of the disclosure to those specific examples.

Specific details are given in the description to provide a thorough understanding of the embodiments. However, embodiments may be practiced without these specific details. For example, well-known circuits, processes, systems, structures, and techniques have been shown without unnecessary detail in order to avoid obscuring the embodiments. This description provides example embodiments only, and is not intended to limit the scope, applicability, or configuration of the invention. Rather, the preceding description of the embodiments will provide those skilled in the art with an enabling description for implementing various embodiments. Various changes may be made in the function and arrangement of elements without departing from the claims.

Also, some embodiments were described as processes depicted as flow diagrams or block diagrams. Although each may describe the operations as a sequential process, many of the operations may be performed in parallel or concurrently. In addition, the order of the operations may be rearranged. A process may have additional steps not included in the figure. Furthermore, embodiments of the methods may be implemented by hardware, software, firmware, middleware, microcode, hardware description languages, or any combination thereof. When implemented in software, firmware, middleware, or microcode, the program code or code segments to perform the associated tasks may be stored in a computer-readable medium such as a storage medium. Processors may perform the associated tasks.

It will be apparent to those skilled in the art that substantial variations may be made in accordance with specific requirements. For example, customized or special-purpose hardware might also be used, and/or particular elements might be implemented in hardware, software (including portable software, such as applets, etc.), or both. Further, connection to other computing devices such as network input/output devices may be employed.

With reference to the appended figures, components that can include memory can include non-transitory machine-readable media. The term "machine-readable medium" and "computer-readable medium," as used herein, refer to any storage medium that participates in providing data that causes a machine to operate in a specific fashion. In embodiments provided hereinabove, various machine-readable media might be involved in providing instructions/code to processing units and/or other device(s) for execution. Additionally or alternatively, the machine-readable media might be used to store and/or carry such instructions/code. In many implementations, a computer-readable medium is a physical and/or tangible storage medium. Such a medium may take many forms, including, but not limited to, non-volatile media, volatile media, and transmission media. Common forms of computer-readable media include, for example, magnetic and/or optical media such as compact disk (CD) or digital versatile disk (DVD), punch cards, paper tape, any other physical medium with patterns of holes, a RAM, a programmable read-only memory (PROM), an erasable programmable read-only memory (EPROM), a FLASH-EPROM, any other memory chip or cartridge, a carrier wave as described hereinafter, or any other medium from which a computer can read instructions and/or code. A computer program product may include code and/or machine-executable instructions that may represent a procedure, a function, a subprogram, a program, a routine, an application (App), a subroutine, a module, a software package, a class, or any combination of instructions, data structures, or program statements.

Those of skill in the art will appreciate that information and signals used to communicate the messages described herein may be represented using any of a variety of different technologies and techniques. For example, data, instructions, commands, information, signals, bits, symbols, and chips that may be referenced throughout the above description may be represented by voltages, currents, electromagnetic waves, magnetic fields or particles, optical fields or particles, or any combination thereof.

Terms, "and" and "or" as used herein, may include a variety of meanings that are also expected to depend at least in part upon the context in which such terms are used. Typically, "or" if used to associate a list, such as A, B, or C, is intended to mean A, B, and C, here used in the inclusive sense, as well as A, B, or C, here used in the exclusive sense. In addition, the term "one or more" as used herein may be used to describe any feature, structure, or characteristic in the singular or may be used to describe some combination of features, structures, or characteristics. However, it should be noted that this is merely an illustrative example and claimed subject matter is not limited to this example. Furthermore, the term "at least one of" if used to associate a list, such as A, B, or C, can be interpreted to mean A, B, C, or a combination of A, B, and/or C, such as AB, AC, BC, AA, ABC, AAB, ACC, AABBCCC, or the like.

Further, while certain embodiments have been described using a particular combination of hardware and software, it should be recognized that other combinations of hardware and software are also possible. Certain embodiments may be implemented only in hardware, or only in software, or using combinations thereof. In one example, software may be implemented with a computer program product containing computer program code or instructions executable by one or more processors for performing any or all of the steps, operations, or processes described in this disclosure, where the computer program may be stored on a non-transitory computer readable medium. The various processes described herein can be implemented on the same processor or different processors in any combination.

Where devices, systems, components, or modules are described as being configured to perform certain operations or functions, such configuration can be accomplished, for example, by designing electronic circuits to perform the operation, by programming programmable electronic circuits (such as microprocessors) to perform the operation such as by executing computer instructions or code, or processors or cores programmed to execute code or instructions stored on a non-transitory memory medium, or any combination thereof. Processes can communicate using a variety of techniques, including, but not limited to, conventional techniques for inter-process communications, and different pairs of processes may use different techniques, or the same pair of processes may use different techniques at different times.

The specification and drawings are, accordingly, to be regarded in an illustrative rather than a restrictive sense. It will, however, be evident that additions, subtractions, deletions, and other modifications and changes may be made thereunto without departing from the claims. Thus, although specific embodiments have been described, these are not intended to be limiting.

## Claims

1. An electronic device comprising:
a first printed circuit module comprising:
a first printed circuit substrate, and
a first set of one or more bonding pads coupled to the first printed circuit substrate;
a second printed circuit module comprising:
a second printed circuit substrate, and
a second set of one or more bonding pads coupled to the second printed circuit substrate;
one or more wire bonds electrically connecting first set of one or more bonding pads to the second set of one or more bonding pads; and
a protective structure covering at least a portion of the one or more wire bonds and coupled with the first printed circuit substrate and second printed circuit substrate.

2. The electronic device of claim 1, wherein the first set of one or more bonding pads are located on a first side of the first printed circuit substrate, and the second set of one or more bonding pads are located on a first side of the second printed circuit substrate, and wherein:
a first portion of a reinforcement plate is coupled to a second side of the first printed circuit substrate opposite the first side of the first printed circuit substrate; and
a second portion of the reinforcement plate is coupled to a second side of the second printed circuit substrate opposite the first side of the second printed circuit substrate.

3. The electronic device of claim 1 or claim 2, wherein the first printed circuit module is coupled to the second printed circuit module.

4. The electronic device of claim 3, wherein:
the first set of one or more bonding pads are located on a first side of the first printed circuit substrate;
the first printed circuit module comprises a cut-out extending from the first side of the first printed circuit substrate to a second side of the first printed circuit substrate opposite the first side of the first printed circuit substrate; and
the one or more wire bonds extend through the cut-out from the first set of one or more bonding pads to the second set of one or more bonding pads.

5. The electronic device of any preceding claim, wherein the protective structure comprises:
a shielding can covering at least a portion of the one or more wire bonds, and/or
a molding compound encapsulating the at least a portion of the one or more wire bonds.

6. The electronic device of any preceding claim, wherein the first printed circuit substrate, the second printed circuit substrate, or both, comprises:
a printed circuit board (PCB) substrate, or
a flexible printed circuit (FPC) substrate.

7. The electronic device of any preceding claim, wherein the first set of one or more bonding pads, the second set of one or more bonding pads, or both, have a pitch of less than 100 microns.

8. A method of interconnecting printed circuits with wire bonding, the method comprising:
forming one or more wire bonds electrically connecting one or more bonding pads of a first printed circuit module to one or more bonding pads of a second printed circuit module, wherein each of the first printed circuit module and the second printed circuit module comprise a respective printed circuit substrate; and
forming a protective structure covering at least a portion of the one or more wire bonds, the protective structure coupled with the respective printed circuit substrate of each of the first printed circuit module and the second printed circuit module.

9. The method of claim 8, wherein the one or more bonding pads of the first printed circuit module are located on a first side of the respective printed circuit substrate of the first printed circuit module, and the one or more bonding pads of the second printed circuit module are located on a first side of the respective printed circuit substrate of the second printed circuit module, and wherein the method further comprises, prior to forming one or more wire bonds:
adhering a first portion of a reinforcement plate to a second side of the respective printed circuit substrate of the first printed circuit module opposite the first side of the respective printed circuit substrate of the first printed circuit module; and
adhering a second portion of the reinforcement plate to a second side of the respective printed circuit substrate of the second printed circuit module opposite the first side of the respective printed circuit substrate of the second printed circuit module.

10. The method of claim 9, wherein:
adhering the first portion of the reinforcement plate to the second side of the respective printed circuit substrate of the first printed circuit module occurs prior to a singulation of the first printed circuit module from a printed circuit panel comprising the first printed circuit module and one or more additional printed circuit modules; and
adhering the second portion of the reinforcement plate to the second side of the respective printed circuit substrate of the second printed circuit module occurs subsequent to the singulation of the first printed circuit module from the printed circuit panel.

11. The method of any of claims 8 to 10, further comprising, prior to forming one or more wire bonds, adhering the first printed circuit module to the second printed circuit module, and optionally wherein:
the one or more bonding pads of the first printed circuit module are located on a first side of the respective printed circuit substrate of the first printed circuit module;
the first printed circuit module comprises a cut-out extending from the first side of the respective printed circuit substrate of the first printed circuit module to a second side of the respective printed circuit substrate of the first printed circuit module opposite the first side of the respective printed circuit substrate of the first printed circuit module; and
forming the one or more wire bonds comprises forming the one or more wire bonds to extend through the cut-out from the one or more bonding pads of the first printed circuit module to the one or more bonding pads of the second printed circuit module.

12. The method of any of claims 8 to 11, wherein forming the protective structure comprises:
securing a shielding can covering at least a portion of the one or more wire bonds, and/or
encapsulating the one or more wire bonds with a molding compound.

13. The method of any of claims 8 to 12, wherein the respective printed circuit substrate of the first printed circuit module, the respective printed circuit substrate of the second printed circuit module, or both, comprises:
a printed circuit board (PCB) substrate, or
a flexible printed circuit (FPC) substrate.

14. The method of any of claims 8 to 13, wherein the one or more bonding pads of the first printed circuit module, the one or more bonding pads of the second printed circuit module, or both, have a pitch of less than 100 microns.

15. A set of electrically connected printed circuit modules comprising:
a first printed circuit module having one or more bonding pads electrically coupled with one or more electrical components of the first printed circuit module;
a second printed circuit module having one or more bonding pads electrically coupled with one or more electrical components of the second printed circuit module;
one or more wire bonds electrically connecting the one or more bonding pads of the first printed circuit module to the one or more bonding pads of the second printed circuit module; and
a protective structure covering at least a portion of the one or more wire bonds.
